# EUROPÄISCHE PATENTSCHRIFT

(11) **EP 2 702 361 B1**
(45) Veröffentlichungstag und Bekanntmachung des Hinweises auf die Patenterteilung: **30.11.2016**
(21) Anmeldenummer: 12716412.7
(22) Anmeldetag: 23.04.2012
(51) Int. Cl.: G01R 21/133, H02J 3/14, H02J 13/00

(54) **ENERGIEVERBRAUCHSERMITTLUNG FÜR HAUSGERÄTE IN EINEM VERBUND MEHRERER HAUSGERÄTE, DIE EIN SYSTEM BILDEN**
ENERGY CONSUMPTION DETERMINATION FOR DOMESTIC APPLIANCES IN A NETWORK OF SEVERAL DOMESTIC APPLIANCES WHICH FORM A SYSTEM
DÉTERMINATION DE LA CONSOMMATION D'ÉNERGIE D'APPAREILS ÉLECTROMÉNAGERS DANS UN RÉSEAU DE PLUSIEURS APPAREILS ÉLECTROMÉNAGERS FORMANT UN SYSTÈME

(30) Priorität: 27.04.2011 DE 102011017574
(43) Veröffentlichungstag der Anmeldung: 05.03.2014
(73) Patentinhaber: BSH Hausgeräte GmbH, 81739 München (DE)
(72) Erfinder: FUCHS, Gerhard, 81827 München (DE); HÄPP, Claudia, 80639 München (DE); PIETSCH, Ingo, 81829 München (DE)
(86) Internationale Anmeldenummer: PCT/EP2012/057388
(87) Internationale Veröffentlichungsnummer: WO 2012/146559

(56) Entgegenhaltungen:
- EP-A1- 1 136 829
- US-A- 4 644 320
- US-A- 5 483 153
- US-A1- 2010 191 487
- HART G W: "NONINTRUSIVE APPLIANCE LOAD MONITORING", PROCEEDINGS OF THE IEEE, IEEE. NEW YORK, US, Bd. 80, Nr. 12, 1. Dezember 1992 (1992-12-01), Seiten 1870-1891, XP000336363, ISSN: 0018-9219, DOI: 10.1109/5.192069

## Beschreibung

Die Erfindung betrifft die Ermittlung des Verbrauchs eines Hausgerätes in einem Verbund mehrerer Hausgeräte, die ein System bilden.

Für einen bewussten und verantwortlichen Umgang mit in einem Haushalt verbrauchter Energie ist es erforderlich, dass der Benutzer von Geräten in einem Haushalt eine genaue und gute Kenntnis über den Verbrauch dieser Geräte hat. Hierzu ist es förderlich, wenn Verbrauchsdaten dieser Geräte, insbesondere Energieeffizienzklassen mit meist einhergehenden Jahresverbrauchsdaten vorliegen. Liegen solche Angaben jedoch nicht vor oder vermag der Benutzer von Hausgeräten den über einem gewissen Zeitraum, wie Jahreszeitraum, mit einem Elektrizitätsunternehmen abzurechnenden Verbrauch elektrischer Energie nicht den Geräten seines Haushaltes in einer plausiblen Weise zuzuordnen, so ist der Benutzer gezwungen, systematisch dem Energieverbrauch einzelner Geräte nachzugehen.

Es liegen der Öffentlichkeit zahlreiche Informationen, insbesondere durch Veröffentlichung im Internet vor, wie bewusster mit elektrischer Energie, insbesondere im Haushalt, vorgegangen werden kann. In einem Beitrag mit der Überschrift "Stromverbrauch mit dem Stromzähler messen", von M. Bockhorst, am 26. April 2011 abrufbar im Internet unter der Adresse http://www.energieinfo.de/energiesparen/energiespartipps_stromverbrauch_mit_dem_stro mzaehler_messen.html,
wird eine Anleitung gegeben, wie durch handschriftliches Notieren des Zählerstandes eines Haushaltsstrom- bzw. Energiezählers vor und nach Abschalten eines Gerätes in einem Haushalt dessen Energieverbrauch ermittelt werden kann. Dieses Vorgehen ist auf praktisch alle Geräte auszudehnen, um zu einem umfassenden Gesamtergebnis zu gelangen. Da ein solches Vorgehen umständlich ist und auch nur eine Momentaufnahme darstellt, dürfte dessen Akzeptanz gering sein.

Ferner werden Messgeräte angeboten, die einer einzelnen Steckdose, wie eine Zeitschaltuhr, zugeordnet werden können und somit für die Messung des Verbrauchs eines Gerätes, das an die Ausgangssteckdose eines solchen Messgerätes angeschlossen wird, herangezogen werden kann. Da im gehobenen Segment, Hausgeräte vielfach, in zum Beispiel Küchenmöbel, eingebaut sind, dürfte diese Art grundsätzlich möglicher Energiemessung pro einzelnes Hausgerät in vielen Fällen ausscheiden. Außerdem ist es unkomfortabel, solche Messgeräte, die in eine Haushaltsteckdose eingesteckt werden müssen, zu bedienen, da Haushaltsteckdosen sich meist knapp, zum Beispiel 30 cm, über dem Fußboden befinden und damit für ein bequemes Ablesen und individuelles Einstellen wenig geeignet sind.

Eine Abhilfe könnte darin bestehen, dass jedem Hausgerät, zum Beispiel in dessen Bedienfeld, eine Anzeige über den Energieverbrauch vorhanden ist. Dies würde jedoch auch zugeordnete Messmittel pro Hausgerät erforderlich machen und damit das jeweilige Hausgerät verteuern.

Aus der US 2010/0191487 A1 geht ein Überwachungs-Gerät und ein zugehöriges Verfahren hervor, wonach elektrische Verbraucher, die sich insbesondere an einer Abzweigung eines Versorgungsnetzes befinden, bezüglich ihres Betriebsverhaltens erkannt werden können. Dazu wird eine sogenannte "Unterschrift" bzw. eine Authentifizierung des jeweiligen Verbrauchers herangezogen, die eine Vielzahl von elektrischen Daten des jeweiligen Verbrauchers, wozu auch das Spektrum des Schwingungsgehaltes des durch den Verbraucher fließenden Stromes gehört, berücksichtigt. Ein die Authentifizierung des jeweiligen Verbrauchers berücksichtigender Datensatz kann auch in einen Speicher gespeichert werden. Das Verhalten der einzelnen Verbraucher, wie auch deren Verbrauch in Bezug auf gewisse Verbrauchszeiträume kann angezeigt werden bzw. es werden Informationen bereitgestellt, die drahtgebunden bzw. drahtlos an einen anderen Ort übertragen werden können. Bei der Lehre nach der US 2010/0191487 A1 wird jedoch davon ausgegangen, dass jedem Verbraucher auch tatsächlich eine "Unterschrift" bzw. eine Authentifizierung zuordenbar ist. Dies dürfte jedoch insbesondere dann auf Schwierigkeiten stoßen, wenn der Aufwand für die Gerätetechnik eines Überwachungsgerätes gering zu_halten ist.

EP1136829A1 beschreibt ein Verfahren zur Messung des Stromverbrauchs eines Hausgeräts durch Detektion eines Strompulses beim Ein- bzw. Ausschalten des Hausgeräts. US2010/0191487A1 beschreibt ein Verfahren zur Erkennung von Hausgeräten anhand von Lastsignaturen. Hart G. W. "Nonintrusive appliance load monitoring", Proceedings of the IEEE, No. 12, Bd. 80, 1992, Seiten 1870-1891, beschreibt die Verwendung von Signaturen zur Erkennung von Hausgeräten.

Hier setzt die Erfindung ein. Es soll eine Möglichkeit gefunden werden, Hausgeräte, die an einem Leitungsstrang, bzw. Abzweig eines Versorgungsnetzes betrieben werden, zusammengefasst einer Betrachtung über deren verbrauchte Energie unterziehen zu können, ohne dass der Aufwand für die Authentifizierung eines einzelnen Verbrauchers bzw. Hausgerätes sich in unübersichtlicher Weise erhöht.

Die Aufgabe der Erfindung besteht daher darin, die Ermittlung des Verbrauchs eines Hausgerätes in einem Verbund mehrerer Hausgeräte, die ein System bilden, auf einfache Weise zu ermöglichen.

Diese Aufgabe wird zunächst nach bei einem System von Hausgeräten, wobei die Hausgeräte an einer Abzweigung eines, insbesondere öffentlichen, Versorgungsnetzes für elektrische Energie mit einer üblichen Netzfrequenz, wie 50 Hz oder 60 Hz, und dementsprechender Netzperiodenzeitabschnitten (20 ms, 16,67 ms) betrieben werden, wobei insbesondere die der Abzweigung zugeführte, verbrauchte Energie erfassbar ist und wobei eine Anzeige- und Messeinheit vorhanden ist, die die Anzeige- und Messung der verbrauchten Energie eines einzelnen Hausgerätes ermöglicht, wobei außerdem deren Funktion für die Ermittlung des Verbrauchs des einzelnen Hausgeräts auf der Analyse einer dem einzelnen Hausgerät zuordenbaren, charakteristischen Struktur von Strom- bzw. Spannungsverläufen innerhalb von Netzperiodenzeitabschnitten, beim Betrieb des einzelnen Hausgeräts, dient, wobei einzelnen Hausgeräten, deren eigene charakteristische Struktur gering ist, dieselbe durch einen Strukturerzeuger (ESM, ES1 bis ESN) ausbildbar bzw. ergänzbar ist und wobei die charakteristische Struktur Oberschwingungen und deren Amplitudenbetrag eines Strom- bzw. Spannungsverlaufs eines im Betrieb befindlichen Hausgeräts umfasst.

Die Erfindung basiert auf der Erkenntnis, dass jedes Hausgerät des Systems von Hausgeräten in einer andauernden Betriebsphase und insbesondere beim Ein- und Ausschalten eine spezifische Netzbelastung hervorruft, da jedes Hausgerät durch die Art der in diesem Gerät aufgenommenen Komponenten, wie ohmschen Widerständen, Induktivitäten und Kapazitäten auch nichtlineare Komponenten, wie gesteuerte und ungesteuerte Dioden, Schalter und dgl. enthält, die also nicht nur eine Verschiebung der Phase des entnommenen Stromes in Bezug auf die Grundwelle der Spannung bezogen auf die Netzfrequenz bedingen, sondern auch einen der Grundwelle überlagerten Stromverlauf aufweisen, der sich bezogen auf die Grundwelle durch Oberwellen bzw. gegenüber der Grundfrequenz höherfrequente Oberschwingungen des Stromes analysieren lässt. Je nach Art der Abzweigung, an der die Hausgeräte sich befinden, können auch den Stromoberschwingungen entsprechende Spannungsoberschwingungen erkannt werden. So, wie oft bereits durch das menschliche Ohr bestimmte Hausgeräte durch deren typische Geräusche, insbesondere in deren Betrieb, erkannt werden können, die meist auf die Stromoberschwingungen zurückgehen und durch Induktion auf einen membranartigen Teil im Gehäuse des jeweiligen Hausgerätes die betreffende Schallschwingung auslösen, kann durch andere, frequenzselektive Rezeptoren, der dem betreffenden Hausgerät charakteristische Oberschwingungsanteil, der also jeweils Schwingungsperiodenabschnitte unterhalb der Dauer der Netzperiode aufweist, in entsprechender Weise erkannt werden. Falls ein einzelnes Hausgerät keine ausreichende, unterscheidbare charakteristische Struktur aufweist, wird ein Strukturerzeuger eingesetzt, der zur Ausbildung einer unterscheidbaren charakteristischen Struktur für dieses Hausgerät, zumindest unterstützend, betreibbar ist.

Die Messung der verbrauchten Energie kann verschiedenartig erfolgen. Es kann ein Zählerprinzip wie bei klassischen Energieverbrauchszählern der Versorgungsunternehmen zugrunde gelegt werden oder es werden neuartige Stromzähler, wie Smart Meter zu Grunde gelegt, die insbesondere auch für kurze Zeitschnitte ein Produkt aus Spannung und Strom bezogen auf einen Messabschnitt erfassen lassen. Wichtig ist jedoch, dass die erfasste Energie sich einem einzelnen Hausgerät oder einer Mehrzahl bestimmter Hausgeräte durch Erkennung von deren Oberschwingungsanteil sicher zuweisen lässt.

Eine Anzeige- und Messeinheit, die auf diesen Prinzipien beruht, kann entweder einem eigens dafür ausgebildeten Gerät zugeordnet sein, oder es wird vorgesehen, dass eines der Hausgeräte des Systems von Hausgeräten diese Anzeige- und Messeinheit aufnimmt. In dem letzteren Fall wird dieses Hausgerät als Master- Hausgerät angesehen.

Bekanntlicherweise wird die in einem Haushalt von einem öffentlichen Energieversorgungsunternehmen bzw. EVU bezogene Energie durch einen eigens von diesem Unternehmen bereitgestellten Strom- bzw. Energiezähler gemessen. Da nach der Erfindung auch die gesamte verbrauchte Energie eines Haushaltes gemessen werden soll, steht es auch an, den vom EVU bereitgestellten Energiezähler durch die erfindungsgemäße Anzeige- und Messeinheit zu ersetzen, was jedoch eine vertraglichen Grundlage mit dem EVU voraussetzen würde. Sofern die elektrische Energie des betreffenden Haushaltes durch eine eigene oder auf privater Vereinbarung begründete Energieversorgung, insbesondere basierend auf regenerativen Energien, bereitgestellt wird, dürfte sich es sich jedoch unschwer anbieten, die erfindungsgemäße Anzeige- und Messeinheit dafür einzusetzen.

Die die charakteristische Struktur bedingenden Oberschwingungen eines Hausgerätes im System der Hausgeräte basieren meist auf den Oberschwingungen des betreffenden Hausgerätes selbst. Es kann jedoch auch vorkommen, dass ein als Hausgerät anzusehender Verbraucher eines Haushaltes keine typischen Einschalt- und Ausschalt- Charakteristika aufweist und auch im Dauerbetrieb keine Oberschwingungen erzeugt, jedoch dessen Verbrauch individualisiert zu erfassen bzw. anzuzeigen ist. Dann sieht die Erfindung vor, dass diesem Hausgerät ein, eine charakteristische Struktur erzeugender, Strukturerzeuger, wie ein passend angeregter Schwingkreis, beizugeben ist, der ein gewisses Maß an Oberschwingungen, das gerade deren Erkennung gestattet, im Sinne einer Rückwirkung in den Abzweig des Netzes einkoppelt. Der Strukturerzeuger selbst sollte fast ohne Verbrauch von Energie betreibbar sein.

Da es auch vorstellbar ist, dass Hausgeräte keine sehr günstige Struktur von Spannungs- und Stromverläufen für deren Erkennung erzeugen, kann es auch angebracht sein, deren Struktur zu verändern um zu der charakteristischen Struktur zu gelangen. Es könnte zum Beispiel erforderlich sein, einen bestimmten Frequenzbereich, der auch störend für den Radiofrequenzbereich wäre, zu unterdrücken und einen anderen Frequenzbereich, der geeignet für die Erkennung einer charakteristischen Struktur ist, verstärkt auszubilden.

Die zur Erfindung gehörende Anzeige- und Messeinheit weist auch einen Visualisierungsteil auf, der den Anzeigebereich des Energieverbrauchs der einzelnen Hausgeräte und vorzugsweise auch aller Hausgeräte des Systems von Hausgeräten aufweist. Wird ein Master- Hausgerät eingesetzt, das ohnehin die Anzeige- und Messeinheit aufnimmt, so bietet es sich an, dass dessen Visualisierungsteil der Bedienblende dieses Master- Hausgerätes zugeordnet ist, während die elektrischen- und elektronischen Komponenten, die der Signal- und Datenverarbeitung der Anzeige- und Messeinheit dienen, im Inneren des Master- Hausgerätes, bevorzugt im Verbund mit dessen eigentlicher Ablauf- Steuerung, aufgenommen sind.

Obwohl es durchaus möglich ist, durch analoge Signalverarbeitung einen als Signal abgebildeten Verlauf, insbesondere des Stromes, des Systems der Hausgeräte auf bestimmte Oberschwingungen und deren Amplitudenbetrag zu untersuchen und damit ein im Betrieb oder bei dessen Beginn oder Ende befindliches Hausgerät identifizieren zu können, wird bevorzugt eine digitale Erkennung der charakteristischen Struktur von Strom- bzw. Spannungsverläufen innerhalb von Netzperiodenzeitabschnitten - fallweise ersetzt oder ergänzt durch die von einem Strukturerzeuger erzeugte Struktur - vorgenommen. Es wird also das dem System bzw. Geräte- Stromverlauf entsprechende bzw. dem Strukturerzeuger entsprechende Signal mittels eines Analog- Digitalwandlers digital umgesetzt und in einem Analysator in Bezug auf einen gespeicherten Vergleichsbereich mittels einer Erkennungseinheit zur Zuordnung der verbrauchten Energie des zugehörigen Hausgerätes herangezogen. Gerade die Vergleichsbereiche lassen sich in digitalen Speichern besonders effizient speichern und einer Datenverarbeitung durch eine Prozessoreinheit unterziehen.

So ist es ohne Weiteres möglich, den Vergleichsbereich für den Analysator durch Initialisierungsprozeduren des Hausgrätesystems zu gewinnen und dann bevorzugt in einem internen Speicher der Anzeige- und Messeinheit zu speichern, der von der Prozessoreinheit über einen Datenbus ein- und ausgelesen werden kann.

Des Weiteren kann der Vergleichsbereich für den Analysator in einem externen Speicher abgespeichert werden. Dieser externe Speicher ist über eine Datenübertragungsstrecke mit der Anzeige- und Messeinheit verbunden, zum Beispiel über das Internet. Ein solcher externer bzw. virtuell vorhandener Speicher kann sich an einem beliebigen Ort in einem Rechner, der eine Verbindung mit dem Internet hat, befinden. Ein solcher Speicher wird auch mit "Wolke" oder "Cloud" bezeichnet. Somit ist es bevorzugt möglich, dass der zuvor erwähnte Vergleichsbereich durch ein Herstellerunternehmen des betreffenden Hausgerätes und zwar auf einem dafür vorgesehenen Rechner bereitgestellt werden kann.

In einen solchen Rechner können auch Daten, die beim Betrieb der Hausgeräte des Hausgerätesystems anfallen, eingelesen werden, so dass das Herstellerunternehmen der Hausgeräte zum Beispiel für die Optimierung der Hausgeräte oder ein Serviceunternehmen darauf zurückgreifen kann. Insbesondere können die Momentanwerte der Leistung der Hausgeräte des Hausgerätesystems in einen solchen Speicher transferiert werden, zumal diese Werte ohnehin auch für den Visualisierungsteil der Anzeige- und Messeinheit über ein Anzeigemittel bereitgestellt werden.

Soweit das erfindungsgemäße System der Hausgeräte in einem Haushalt, insbesondere zusammen mit dem Master- Hausgerät zu installieren ist, kann es zweckmäßig sein, darauf ausgerichtetes Installationsmaterial bereitzustellen, zum Beispiel als Bausatz. Somit kann ein Abzweig von einer Verteilerstelle des Energieversorgungsnetzes in dem betreffenden Haushalt zuerst zu dem Master- Hausgerät geführt werden und dann vom Master-Hausgerät ausgehend den weiteren Hausgeräten zugeführt werden.

Soweit die Erfindung durch auf die unabhängigen Ansprüche rückbezogene, nicht selbständige Ansprüche weitergebildet wird, so soll es so sein, dass eine zunächst angegebene Kette von Rückbeziehungen nicht einschränkend in Bezug auf die insgesamt mitgeteilte Lehre anzusehen ist, soweit auch andere Kombinationen von Merkmalen von Ansprüchen sich als geeignet und ausführbar aus Sicht des Fachmanns ergeben.

Im Folgenden wird die Erfindung anhand von in der beigefügten Zeichnung schematisch dargestellten Ausführungsbeispielen genauer beschrieben. Gleiche Bezugszeichen bezeichnen jeweils gleiche oder vergleichbare Teile. Die Figuren der Zeichnung werden zunächst kurz erläutert.
Fig. 1 zeigt eine Gesamtanordnung des Systems von Hausgeräten in Bezug auf einen Haushalt;
Fig. 2 zeigt stark vereinfacht einen funktionellen Zusammenhang zur Gewinnung der jeweiligen Geräte sowie insgesamt allen Geräten des Systems zuzuordnenden, verbrauchten Energie.

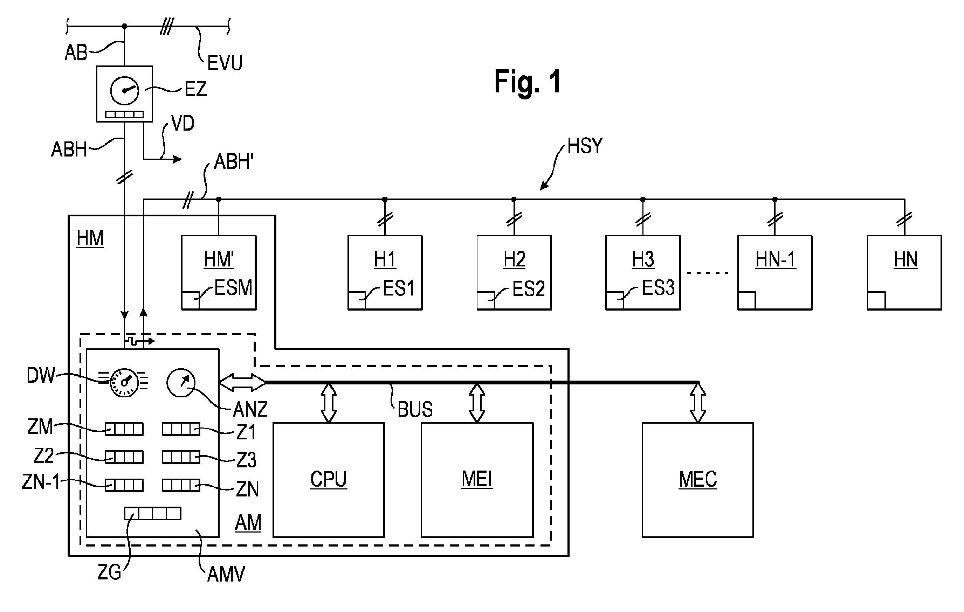

In Fig. 1 ist zunächst eine Versorgungsleitung eines Netzes eines öffentlichen Versorgungsunternehmens EVU dargestellt. Ein Abzweig AB dieses Netzes wird in einem Haushalt einem System von Hausgeräten zugeführt. Es ist zunächst ein üblicher Energiezähler EZ des EVU vorgesehen, der nach Vorgaben des EVU ausgestaltet ist bzw. vom diesem bereitgestellt wird. Es kann sich auch um einen intelligenten Energiezähler, meist mit Smart Meter bezeichnet, handeln, dessen Ausgangssignale auch die Einschaltbedingungen von Hausgeräten beeinflussen können, insbesondere soweit es sich um Tarifinformationen handelt. Diese Möglichkeit wird jedoch bei der nachfolgenden Beschreibung einer Ausführungsform der Erfindung nicht weiter dargestellt, jedoch ist es vorliegend nicht ausgeschlossen, diese Möglichkeit auch zu berücksichtigen.

Am Ausgang des Energiezählers EZ des EVU sind im Wesentlichen die Hausgeräte angeschlossen, die das nach der Erfindung zu betrachtende System von Hausgeräten HSY betreffen. Außerhalb dieses Systems gibt es noch diverse Verbraucher VD, wie Beleuchtungen mit Energiesparlampen oder Heizungsumwälzpumpen, deren Energieverbrauchsanteile kaum ins Gewicht fallen und daher bei dem System von Hausgeräten, bei dieser beispielsweise dargestellten Ausführungsform, nicht mehr weiter in Einzelheiten geschildert werden. Generell ist es jedoch vorliegend möglich, alle Geräte eines Haushaltes zu berücksichtigen.

Der Abzweig ABH mit den Hausgeräten des Systems von Hausgeräten HSY wird zunächst durch eine Anzeige- und Messeinheit AM hindurchgeschleift, bevor alle Hausgeräte des Systems von Hausgeräten HSY mit Strom bzw. elektrischer Energie versorgt werden. Die Anzeige- und Messeinheit AM weist zunächst einen Visualisierungsteil AMV auf, der an die Gestaltung einer Bedienblende eines Hausgerätes angepasst werden kann oder auch anders gestaltet sein kann. Wichtig ist nur, dass die Energieverbrauchswerte der Hausgeräte des Systems von Hausgeräten HSY angezeigt werden können und dass weiter eine aktuelle Bedingung, wie ein aktueller Verbrauch eines einzelnen Hausgerätes als Leistung oder als Energie für einen Integrationszeitraum, wie eine Stunde, zum Beispiel ausgewählt über einen Drehwähler DW, über ein analoges oder digitales Anzeigeinstrument ZN angezeigt werden kann.

Die Geräteteile der Anzeige- und Messeinheit AM, die nicht der direkten Visualisierung dienen, betreffen deren Informationsverarbeitung. Es ist ein Datenaustausch über einen Datenbus BUS vorgesehen, der einerseits zwischen den Messfühlern (nicht dargestellt) für die Augenblickswerte von Strom und Spannung einer zentralen Verarbeitungseinheit CPU dient, jedoch andererseits die Daten über die gewonnenen Ergebnisse betreffend der momentane Leistung eines Hausgerätes sowie des daraus zusammengefasst errechneten Verbrauchs an Energie pro Hausgerät dem Visualisierungsteil AVM zuführt. Ferner steht der Datenbus BUS mit Speichern, die intern, bezeichnet mit MEI, des Gerätes AM ausgebildet sind und extern des Gerätes AM, bezeichnet mit MEC, vorliegend sind, in Verbindung. Diese externe Verbindung zu dem Speicher MEC kann über das Internet über Kabel oder drahtlos, also über eine Datenübertragungsstrecke, erfolgen. Der externe Speicher kann sich auf einem beliebigen, weltweit befindlichen Rechner, realisiert sein. Für solche Speicher auf einem entfernt befindlichen Rechner ist die Bezeichnung Cloud (Wolke) üblich. Auf die unter der zentralen Recheneinheit CPU stattfindenden Verarbeitungsabläufe, aufgrund gespeicherter Programme in dem Speicher MEI wird nachfolgend noch eingegangen werden.

Es ist vorgesehen, dass die gesamte Mess- und Anzeigeeinheit AM entweder als eigenständiges Gerät ausgebildet ist und dabei der Abzweig zu dem System von Hausgeräten HSY durch dieses Gerät hindurchgeschleift ist, um die Augenblickswerte von Spannungen und Strömen erfassen zu können. Es ist jedoch auch möglich, dass die Anzeige- und Messeinheit AM zum Bestandteil eines Hausgerätes wird, das dann als Master- Hausgerät HM bezeichnet wird. Das eigentliche Hausgerät des Master- Hausgeräts wird dann mit HM' gekennzeichnet. Es wird am Ausgang der durch die Mess- und Anzeigeeinheit AM hindurch- geführten Schleife (nur angedeutet) angeschlossen, wobei dieser Abzweig ausgehend vom Ausgang der Anzeige- und Messeinheit dann mit ABH' bezeichnet wird. An diesen Abzweig sind dann weitere Hausgeräte H1, H2, H3 .. HN-1 und HN angeschlossen.

Es bietet sich dabei an, als Master- Hausgerät HM ein Hausgerät, wie Waschmaschine oder Waschtrockner vorzusehen, das ohnehin nahe dem Abzweig ABH der Hausinstallation (mit Stromzähler EZ) sich befindet. Somit ist es auch leicht möglich, für die weiteren Hausgeräte H1 bis HN den Abzweig ABH' in der Hausinstallation (bevorzugt für die Küche, wie Geschirrspüler, Backofen, Induktionsherd, Kühl- und Gefrierschrank) zugänglich zu machen. Es kann ein Bausatz dafür vorgesehen werden.

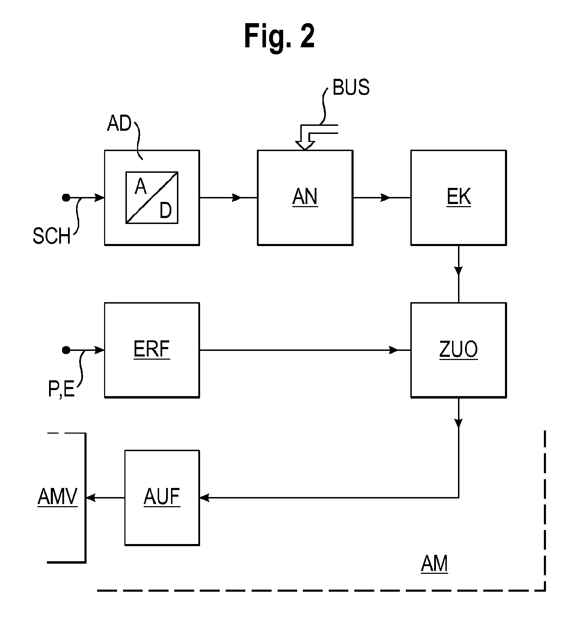

Die Funktionsweise der Anzeige- und Messeinheit AM soll nun im Folgenden anhand der in Fig. 2 dargestellten Funktionseinheiten erläutert werden. Mittels der in die Anzeige- und Messeinheit AM eingeschleiften Leitung vom Abzweig ABH zu ABH' kann ein Momentanwert von Spannung und / oder Strom abgegriffen gemessen bzw. als Signal SCH abgebildet werden. Dabei geben die Oberwellen bzw. Oberschwingungen, insbesondere des Stromes, darüber Aufschluss, welches Hausgerät bzw. welche Hausgeräte in Betrieb sind. Bevorzugt wird das Schwingungsgemisch in Digitalwerte mittels eines Wandlers AD umgewandelt, die zu einem genauen Abbild der Schwingungen in Zeit- und Amplitudendiskreter Weise führen. Solche Digitalwerte lassen sich gut in Bezug auf Vergleichswerte bzw. Vergleichsbereiche analysieren. Es kommt nur darauf an, dass für aktuell analysierte Werte auch Vergleichswerte oder Vergleichsbereiche verfügbar gemacht werden können. Hierzu ist es besonders vorteilhaft, wenn die Speicherkapazität der Anzeige- und Messeinheit AM durch den bereits zuvor erwähnten, externen Speicher in einer beliebigen Datenverarbeitungsanlage, wie Wolke (Cloud) erweitert werden kann und somit ein Analysator AN auf diese Vergleichswerte für ein Oberschwingungsbündel, das charakteristisch für ein bestimmtes Hausgerät ist, zurückgreifen kann. Die Vergleichswerte selbst lassen sich durch Initialisierungs-Prozeduren gewinnen. Weiterhin ist es möglich, dass unterstützend durch einen selbstlernenden Prozess immer bessere Vergleichswerte bzw. Vergleichbereiche für ein bestimmtes Hausgerät zur Verfügung stehen. Das Hausgerät kann somit erkannt werden. Dazu gibt de Analysator AN das Ergebnis über das betreffende Hausgerät an die Erkennungseinheit EK zur weiteren Daten-Verarbeitung weiter.

Die vorab erwähnten Vergleichswerte bzw. Vergleichsbereiche können jedoch auch beim Herstellerunternehmen der Hausgeräte gewonnen und in dem externen Speicher MEC zum Abruf über den Datenbus BUS bereitgestellt werden.

Ferner ist vorgesehen, dass in einer Verarbeitungs- und Erfassungseinheit ERF aus den Momentanwerten für die Spannung und den Strom ein Leistungswert P gebildet wird, der durch Integration über einen bestimmten Zeitabschnitt zu der verbrauchten Energie E eines bestimmten Hausgerätes führt. Es ist lediglich erforderlich, dass die erfasste Leistung P dem erkannten Hausgerät über einen Zuordner ZUO zugeordnet wird, so dass sich ein erfasster Leistungsanteil bzw. aufintegrierter Energieanteil einem bestimmten Hausgerät HM', H1 bis HN zuordnen lässt. Dabei ist vorgesehen, dass diese Zuordnung nicht nur dann funktioniert, wenn lediglich ein Hausgerät in Betrieb ist, da markante Betriebsabläufe der Hausgeräte des Systems von Hausgeräten zu Leistungssprüngen führen, so dass die aufintegrierbaren Leistungsanteile des einzelnen Hausgerätes, die einem stattgefundenen Energieverbrauch entsprechen, mit sehr hoher Genauigkeit zugeordnet werden können. Auch die obige beschriebene Selbstlernfähigkeit bei der Verarbeitung durch die zentrale Verarbeitungseinheit CPU trägt zu diesem Ergebnis bei. Im Gesamten wird in einer Einheit AUF pro Hausgerät ein individualisierter bzw. als Signal aufbereiteter Leistungs- bzw. Energieanteil bereitgestellt, der im Visualisierungsteil AMV der Anzeige- und Messeinheit AM zu den Zählerständen ZM, Z1, Z2, Z3 bis ZN betreffend der verbrauchten Energie führt, wobei auch ein Summenzähler ZG vorhanden ist (vgl. Fig. 1). Ferner ist es so auch möglich, im Visualisierungsteil AMV die momentan in Bezug auf ein Hausgerät verbrauchte Leistung anzuzeigen, indem über den obig beschriebenen Drehwähler DW die entsprechende analoge oder digitale Anzeige ANZ aktiv geschaltet wird. Darüber hinaus können alle Daten, die über den Visualisierungsteil AMV zur Anzeige gebracht werden, auch über den Datenbus BUS (vgl. Fig. 1) an einen externen Ort, zum Beispiel den Speicher MEC, übermittelt werden, so dass eine dritte Person außerhalb des Haushaltes mit dem System von Hausgeräten HSY Erkenntnisse über die Hausgeräte gewinnen kann. Dies kann eine Forschungsabteilung des Herstellerunternehmens der Hausgeräte oder ein Serviceunternehmen für die Wartung der Hausgeräte sein.

Der anhand der Fig. 2 beschriebene Funktionsablauf beruht darauf, dass die Oberschwingungen, die insbesondere der Stromverlauf des Abzweigs ABH' aufweist, ausreicht, um ein einzelnes Hausgerät des Systems von Hausgeräten HSY erkennen zu können. Es ist jedoch auch möglich, dass die charakteristische Struktur von Strom- bzw. Spannungsverläufen, durch einen geräteinternen Strukturerzeuger erzeugt wird. Solche Strukturerzeuger sind zugeordnet zu den Hausgeräten des Systems von Hausgeräten HSY in Fig. 1 kenntlich gemacht, vgl. ESM, ES 1, ES2, ES3 bis ESM. Dabei ist es möglich, dass die Strukturerzeuger anstatt der geräteeigenen Strukturen der Strom- bzw. Spannungsverläufe der Hausgeräte zum Einsatz gelangen. Es kann dann die Analyse vereinfacht sein. Demgegenüber ist es erforderlich, jedes Hausgerät mit einem solchen Struktur-Erzeuger auszurüsten. Es ist jedoch auch möglich, nur solche Hausgeräte mit einem Strukturerzeuger auszurüsten, deren Strom- und Spannungsverläufe keine erkenn- bzw. auswertbare charakteristische Struktur aufweisen bzw. es ist auch möglich, die vom Hausgerät selbst erzeugte Struktur zu unterstützen bzw. so zu verändern, dass keine Funkstörungen auftreten, also unerlaubte Frequenzbereiche ausgeblendet werden und die charakteristische Struktur in einen erlaubten Frequenzbereich transformiert wird.

### Bezugszeichenliste

- EVU: Netz des Versorgungsunternehmens
- EZ: Energiezähler des EVU
- AB: Abzweig
- ABH: Abzweig Hausgeräte
- HSY: System von Hausgeräten
- VD: diverse Verbraucher
- AM: Anzeige- und Messeinheit
- AMV: Visualisierungsteil von AM
- CPU: zentrale Verarbeitungseinheit
- MEI: Speicher / Memory intern
- MEC: Speicher / Memory extern / Cloud
- ANZ: Anzeige Momentanwert
- DW: Drehwähler
- ZM: Anzeige Verbrauch Master- Hausgerät
- Z1 bis ZN: Anzeige Hausgerät H1 bis HN
- ZG: Anzeige aller Hausgeräte
- HM: Master- Hausgerät (mit AM)
- HM': Hausgerät in HM
- H1 bis HN: weitere Hausgeräte
- ESM: Strukturerzeuger im Master- Hausgerät
- ES1 bis ESN: weitere Strukturerzeuger
- CPU: zentrale Verarbeitungseinheit
- BUS: Datenbus
- SCH: Signal charakteristische Struktur
- AD: Analog- Digital- Wandler
- AN: Analysator
- EK: Erkennungseinheit
- ERF: Erfassungsbereich P und E
- P: Leistung
- E: Energie
- ZUO: Zuordner
- AUF: Aufbereitung für Anzeigen

## Patentansprüche

1. System von Hausgeräten, wobei die Hausgeräte an einer Abzweigung eines, insbesondere öffentlichen, Versorgungsnetzes für elektrische Energie mit einer üblichen Netzfrequenz betrieben werden, wobei insbesondere die der Abzweigung zugeführte, verbrauchte Energie erfassbar ist, und wobei eine Anzeige- und Messeinheit vorhanden ist, die die Anzeige und Messung der verbrauchten Energie eines einzelnen Hausgerätes ermöglicht, wobei deren Funktion für die Ermittlung des Verbrauchs des einzelnen Hausgeräts auf der Analyse einer dem einzelnen Hausgerät zuordenbaren, charakteristischen Struktur von Strom- bzw. Spannungsverläufen innerhalb von Netzperiodenzeitabschnitten beim Betrieb des einzelnen Hausgeräts basiert, wobei einzelnen Hausgeräten, deren eigene charakteristische Struktur gering ist, dieselbe durch einen Strukturerzeuger (ESM, ES1 bis ESN) ausbildbar bzw. ergänzbar ist; wobei die charakteristische Struktur Oberschwingungen und deren Amplitudenbetrag eines Strom- bzw. Spannungsverlaufs eines im Betrieb befindlichen Hausgeräts umfasst.

2. System nach Anspruch 1, **dadurch gekennzeichnet, dass** die Anzeige- und Messeinheit (AM) innerhalb eines eigens dafür vorgesehenen Gerätes ausgebildet ist.

3. System nach Anspruch 1, **dadurch gekennzeichnet, dass** die Anzeige- und Messeinheit (AM) innerhalb eines Master-Hausgerätes (HM) ausgebildet ist.

4. System nach einem der Ansprüche 1 bis 3, **dadurch gekennzeichnet, dass** die Anzeige- und Messeinheit (AM) einen Visualisierungsteil (AMV) aufweist, der Anzeigebereiche (ZM, Z1 bis ZN; ZG) des Energieverbrauchs der einzelnen Hausgeräte und vorzugsweise auch aller Hausgeräte des Systems (HSY) von Hausgeräten aufweist.

5. System nach Ansprüchen 3 und 4, **dadurch gekennzeichnet, dass** der Visualisierungsteil (AMV) der Bedienblende des Masterhausgerätes (HM) zugeordnet ist.

6. System nach einem der vorhergehenden Ansprüche, **dadurch gekennzeichnet, dass** ein der charakteristischen Struktur von Strom- bzw. Spannungsverläufen innerhalb von Netzperiodenzeitabschnitten bzw. von Strukturerzeugern (ESM, ES1 bis ESN) entsprechendes Signal mittels eines Analog- Digitalwandlers (AD) digital umgesetzt wird und in einem Analysator (AN) in Bezug auf einen gespeicherten Vergleichsbereich mittels einer Erkennungseinheit (EK) zur Zuordnung der verbrauchten Energie des zugehörigen Hausgerätes (HM, H1 bis HN) heranziehbar ist.

7. System nach Anspruch 6, **dadurch gekennzeichnet, dass** der Vergleichsbereich für den Analysator (AN) durch Initialisierungsprozeduren des Hausgrätesystems gewinnbar ist und bevorzugt in einem internen Speicher (MEI) der Anzeige- und Messeinheit (MA) abspeicherbar ist.

8. System nach Anspruch 6, **dadurch gekennzeichnet, dass** der Vergleichsbereich für den Analysator (AN) in einem externen Speicher (MEC), der eine Datenleitung (BUS) zu der Anzeige- und Messeinheit (MA) aufweist, abspeicherbar und zugreifbar ist, wobei bevorzugt dieser Vergleichsbereich durch ein Herstellerunternehmen des betreffenden Hausgerätes bereitstellbar ist.

9. System nach einem der Ansprüche 1 bis 3, **dadurch gekennzeichnet, dass** das die Anzeige- und Messeinheit (AM) einen Visualisierungsteil (AMV) aufweist, der auch selektiv, wie über Drehschalter ausgelöst, ein Anzeigemittel (ANZ) aufweist, das die momentan für ein einzelnes Hausgerät (HM', H1 bis HN) benötigte Leistung anzeigt, wobei insbesondere dieser Wert auch auf einem externen Speicher (MEC) abspeicherbar ist, so dass ein Herstellerunternehmen oder ein Serviceunternehmen darauf zurückgreifen kann.

10. System nach einem der vorhergehenden Ansprüche, **dadurch gekennzeichnet, dass** ein Bausatz bereitgestellt wird, um das System (HSY) in Bezug auf einen Haushalt in bevorzugter Weise ausbilden zu können.

## Claims

1. System of domestic appliances, wherein the domestic appliances are operated on a branch of an, in particular public, supply network for electrical energy at a standard network frequency, wherein in particular the consumed energy supplied to the branch can be detected and wherein a display and measuring unit is present, which allows the display and measurement of the consumed energy of an individual domestic appliance,
wherein its function of determining the consumption of the individual domestic appliance is based on the analysis of a characteristic structure of current and voltage profiles that can be assigned to the individual domestic appliance within network period time segments during operation of the individual domestic appliance, wherein the characteristic structure of individual domestic appliances whose own characteristic structure is small can be formed or added to by a structure generator (ESM, ES1 to ESN); wherein the characteristic structure comprises harmonics and their amplitude size of a current or voltage profile of a domestic appliance that is operating.

2. System according to claim 1, **characterised in that** the display and measuring unit (AM) is configured within a device provide specifically for the purpose.

3. System according to claim 1, **characterised in that** the display and measuring unit (AM) is configured within a master domestic appliance (HM).

4. System according to one of claims 1 to 3, **characterised in that** the display and measuring unit (AM) has a visualisation part (AMV), which comprises display regions (ZM, Z1 to ZN; ZG) for the energy consumption of the individual domestic appliances and preferably also all the domestic appliances in the system (HSY) of domestic appliances.

5. System according to claims 3 and 4, **characterised in that** the visualisation part (AMV) is assigned to the operating panel of the master domestic appliance (HM).

6. System according to one of the preceding claims, **characterised in that** a signal corresponding to the characteristic structure of current or voltage profiles within network period time segments or from structure generators (ESM, ES1 to ESN) is converted to digital by means of an analogue/digital converter (AD) and can be used in an analyser (AN) in respect of a stored comparison range by means of an identification unit (EK) for assigning the consumed energy of the associated domestic appliance (HM, H1 to HN).

7. System according to claim 6, **characterised in that** the comparison range for the analyser (AN) can be obtained by initialisation procedures of the domestic appliance system and stored preferably in an internal storage unit (MEI) of the display and measuring unit (MA).

8. System according to claim 6, **characterised in that** the comparison range for the analyser (AN) can be stored and accessed in an external storage unit (MEC), which has a data line (BUS) to the display and measuring unit (MA), it being possible for said comparison range preferably to be supplied by a manufacturer of the relevant domestic appliance.

9. System according to one of claims 1 to 3, **characterised in that** the display and measuring unit (AM) has a visualisation part (AMV), which also selectively comprises a display means (ANZ), as triggered by way of rotary switches, which displays the power required instantaneously for an individual domestic appliance (HM', H1 to HN), it being possible also for said value to be stored in particular on an external storage unit (MEC), so that a manufacturer or service company can have access thereto.

10. System according to one of the preceding claims, **characterised in that** an assembly kit is supplied, in order to be able to configure the system (HSY) in a preferred manner in respect of a household.

## Revendications

1. Système d'appareils électroménagers, les appareils électroménagers fonctionnant sur une dérivation notamment d'un réseau d'alimentation en énergie électrique public avec une fréquence de réseau usuelle, l'énergie consommée amenée à ladite dérivation pouvant notamment être détectée, et une unité d'affichage et de mesure étant prévue, qui permet d'afficher et de mesurer l'énergie consommée d'un appareil électroménager individuel et dont la fonction de détermination de la consommation de l'appareil électroménager individuel est basée sur l'analyse d'une structure caractéristique, associée à l'appareil électroménager individuel, de variations d'intensité et/ou de tension à l'intérieur d'intervalles de temps de périodes de réseau lors du fonctionnement de l'appareil électroménager individuel, sachant que pour des appareils électroménagers individuels dont la structure caractéristique propre est faible, cette dernière peut être formée ou complétée par un générateur de structure (ESM, ES1 à ESN), la structure caractéristique comprenant des oscillations harmoniques et leur valeur d'amplitude d'une variation de courant et/ou de tension d'un appareil électroménager en fonctionnement.

2. Système selon la revendication 1, **caractérisé en ce que** l'unité d'affichage et de mesure (AM) est réalisée à l'intérieur d'un appareil spécialement prévu à cet effet.

3. Système selon la revendication 1, **caractérisé en ce que** l'unité d'affichage et de mesure (AM) est réalisée à l'intérieur d'un appareil électroménager maître (HM).

4. Système selon l'une des revendications 1 à 3, **caractérisé en ce que** l'unité d'affichage et de mesure (AM) comporte une partie de visualisation (AMV), laquelle présente des zones d'affichage (ZM, Z1 à ZN ; ZG) de la consommation d'énergie des appareils électroménagers individuels et de préférence aussi de tous les appareils électroménagers du système (HSY) d'appareils électroménagers.

5. Système selon les revendications 3 et 4, **caractérisé en ce que** la partie de visualisation (AMV) est associée au bandeau de commande de l'appareil électroménager maître (HM).

6. Système selon l'une des revendications précédentes, **caractérisé en ce qu'**un signal correspondant à la structure caractéristique de variations de courant et/ou de tension à l'intérieur d'intervalles de temps de périodes de réseau, resp. de générateurs de structure (ESM, ES1 à ESN), est converti en numérique au moyen d'un convertisseur analogique-numérique (AD) et peut être utilisé dans un analyseur (AN), par rapport à une gamme de comparaison mémorisée, au moyen d'une unité de reconnaissance (EK) pour l'association de l'énergie consommée de l'appareil électroménager concerné (HM, H1 à HN).

7. Système selon la revendication 6, **caractérisé en ce que** la gamme de comparaison pour l'analyseur (AN) peut être obtenue par des procédures d'initialisation du système d'appareils électroménagers et être enregistrée dans une mémoire interne (MEI) de l'unité d'affichage et de mesure (AM).

8. Système selon la revendication 6, **caractérisé en ce que** la gamme de comparaison pour l'analyseur (AN) peut être enregistrée, et est accessible, dans une mémoire externe (MEI) ayant une ligne de données (BUS) jusqu'à l'unité d'affichage et de mesure (AM), cette gamme de comparaison pouvant de préférence être fournie par une entreprise productrice de l'appareil ménager concerné.

9. Système selon l'une des revendications 1 à 3, **caractérisé en ce que** l'unité d'affichage et de mesure (AM) comporte une partie de visualisation (AMV), laquelle présente de façon sélective, par exemple déclenché par l'intermédiaire de commutateurs rotatifs, un moyen d'affichage (ANZ) qui affiche la puissance actuellement requise pour un appareil ménager individuel (HM', H1 à HN), cette valeur en particulier pouvant être enregistrée également sur une mémoire externe (MEC) de façon qu'une société productrice ou une société de service puisse y accéder.

10. Système selon l'une des revendications précédentes, **caractérisé en ce qu'**un kit de montage est fourni pour pouvoir former le système (HSY) de manière adaptée par rapport à un ménage.
